# EUROPEAN PATENT APPLICATION

(11) **EP 2 175 479 A1**
(43) Date of publication of application: **14.04.2010**
(21) Application number: 07800773.9
(22) Date of filing: 23.08.2007
(51) Int. Cl.: H01L 21/304, H01L 21/306

(54) **A METHOD FOR PROCESSING A SEMICONDUCTOR SUBSTRATE SURFACE AND A CHEMICAL PROCESSING DEVICE FOR THE SEMICONDUCTOR SUBSTRATE SURFACE**

(30) Priority: 16.07.2007 CN 200710135836
(71) Applicant: Wuxi Suntech Power Co. Ltd., New District, Wuxi Jiangsu 214-028 (CN)
(72) Inventor: JI, Jingjia, Wuxi Jiangsu 214028 (CN); SHI, Zhengrong, Wuxi Jiangsu 214028 (CN); QIN, Yusen, Wuxi Jiangsu 214028 (CN)
(74) Representative: HOFFMANN EITLE
(86) International application number: PCT/CN2007/002553
(87) International publication number: WO 2009/009931

(57) **Abstract**

The present invention relates to the industrial field of semiconductor manufacture. The present invention provides a method for chemically processing a surface of a semiconductor substrate comprising the steps of: placing a semiconductor substrate (4) above a chemical solution (5) by a shaft (2) and making the lower surface of the semiconductor substrate (4) be at a certain distance from the liquid surface of the chemical solution (5); and jetting the chemical solution onto the lower surface of the semiconductor substrate by a jet apparatus (3) to perform the chemical processing on the lower surface, and a device for the same including a chemical tank (1) containing a chemical solution, a shaft (2) for supporting the semiconductor substrate (4) above the chemical solution, and a jet apparatus (3) for jetting the chemical solution onto the lower surface of the semiconductor substrate (4). The method may perform a chemical treatment on one side of a semiconductor substrate without any protection for the other side.

## Description

### FIELD OF THE INVENTION

The present invention relates to a method for chemically processing a semiconductor substrate in the semiconductor manufacturing industry, particularly, to a method for wet-chemically processing a semiconductor substrate in the field for manufacturing semiconductor solar cells, and more particularly, to a method for wet-chemically processing a single side of a semiconductor substrate.

### BACKGROUND

It is a common process in the semiconductor manufacturing industry to perform a surface treatment of a semiconductor substrate with chemical solutions, such as the processes for etching, cleaning, etc. the surface of a semiconductor substrate. In general, the above wet-chemical processes are performed by immersing a semiconductor substrate in a chemical solution. In this case, both sides of the semiconductor substrate are processed wet-chemically.

In many cases, during the industrial production of a semiconductor, however, only a single side of a semiconductor substrate is required to be processed wet-chemically in many processes, such as the process for etching a single side of silicon or oxide substrate. In these cases, the desired wet-chemical treatment on a single side of the semiconductor substrate can not be achieved by the above processing method wherein the semiconductor substrate is immersed into a chemical solution.

In order to wet-chemically process a single side of the semiconductor substrate, it is general practice in the prior art to protect the surface which does not need the chemical treatment from being in contact with and treated by the chemical solution by using a mask, and thus only the unprotected surface of the semiconductor substrate is processed. For example, in the industrial production of a semiconductor, photoresist is often used to protect the surface that does not need the treatment so as to realize the single-side chemical treatment. In the above method wherein a wet-chemical processing is performed after protecting one surface by using a mask, however, there are great disadvantages in that, it not only adds the steps for plating and cleaning the film during the process, but also increases the cost of raw materials and the amount of waste water generated during the process, which makes the whole processing procedure more complicated and significantly increases the cost of the product.

In the prior art, some improvements have been made to address the disadvantages of the above masking method. That is, during the chemical processing, the semiconductor substrate is not placed vertically in the chemical solution in the chemical tank, but placed or floated horizontally on the surface of the chemical solution in the chemical tank. When the semiconductor substrate is placed or floated horizontally on the liquid surface of the chemical solution, only the lower surface of the semiconductor substrate is in contact with the liquid surface of the chemical solution, thus realizing the single-side treatment (etching or cleaning) of the semiconductor substrate.

However, there are still great disadvantages or defects during the actual operation in the above modified method for the single-side treatment of the semiconductor substrate. The liquid surface of the chemical solution often fluctuates slightly due to the environmental influence. Since the used semiconductor substrate becomes thinner, when the semiconductor substrate has a very thin thickness, for example, less than 500 µm, and is processed by placing or floating horizontally on the liquid surface of the chemical solution, a slight fluctuation of the liquid surface of the chemical solution will wet the upper surface of the semiconductor substrate or at least its margins with the chemical solution. In addition, when the semiconductor substrate is treated by placing or floating horizontally on the liquid surface of the chemical solution, the chemical solution will be sucked to the upper surface of the semiconductor substrate due to siphon action resulted from the surface tension of the solution. In both of the above cases, a chemical treatment occurs on the upper surface of the semiconductor substrate which does not need the treatment, thus causing sub-standard quality and/or poor uniformity of the semiconductor substrate and failing to meet the requirements.

### SUMMARY OF THE INVENTION

To address the above defects in the prior art, the present invention provides a new method for chemically processing a surface of a semiconductor substrate and a device for the same. The method and the device can be used to chemically process a single side of a semiconductor substrate.

Thus, an object of the present invention is to provide a method for chemically processing a surface of a semiconductor substrate, which may chemically process only a single side of a semiconductor substrate without any protection for the other side.

Another object of the present invention is to provide a device for chemically processing a surface of the semiconductor substrate, which may chemically process only a single side of the semiconductor substrate without wetting the other side due to the fluctuation in the liquid surface of the chemical solution and/or siphon action.

In order to achieve the above objects, the present invention provides a method for chemically processing a surface of a semiconductor substrate comprising the following steps of: placing a semiconductor substrate above a chemical solution by a shaft and making the lower surface of the semiconductor substrate be at a certain distance from the liquid surface of the chemical solution; and wet-chemically processing the lower surface of the semiconductor substrate by jetting the chemical solution onto the lower surface of the semiconductor substrate via a jet apparatus provided under the semiconductor substrate.

The present invention provides a device for chemically processing a surface of a semiconductor substrate, which comprises a chemical tank for containing a chemical solution, a shaft for supporting the semiconductor substrate above the chemical solution, and a jet apparatus for jetting the chemical solution onto the lower surface of the semiconductor substrate.

The present invention has several advantageous benefits. The chemical processing method and device thereof according to the present invention allow the chemical solution in contact with the lower surface of the semiconductor substrate through jetting the chemical solution onto the lower surface of the semiconductor substrate by using a jet apparatus provided under the semiconductor substrate. While the lower surface of the semiconductor substrate is ensured to be in contact with the chemical solution, the distance between the lower surface of the semiconductor substrate and the liquid surface of the chemical solution contained in the chemical tank may be increased efficiently so as to eliminate the possibility of wetting the upper surface of the semiconductor substrate by the chemical solution.

Under the conditions for industrial production, the liquid surface of the chemical solution often fluctuates to a certain extent due to the influence of the movement of various parts and vibration in the environment. Since a semiconductor substrate generally has a thickness of less than 500 µm, in the case of when the lower surface of the semiconductor substrate is too close to the liquid surface of the chemical solution, the upper surface of the semiconductor substrate is easy to be wetted by the chemical solution due to the fluctuation of the liquid surface of the chemical solution. On the other hand, in the case of when the lower surface of the semiconductor substrate is too far away from the liquid surface of the chemical solution, it may not be in contact with the liquid surface of the chemical solution, and thus may not be wet-chemically processed. By using the chemical processing method and device according to the present invention, in which a jet apparatus is used to jet a chemical solution onto the lower surface of a semiconductor substrate, the lower surface of the semiconductor substrate may be in contact with the chemical solution and wetted. Therefore, while the lower surface of the semiconductor substrate is ensured to be in contact with the chemical solution, the chemical processing method and device according to the present invention may efficiently increase the distance between the lower surface of the semiconductor substrate and the liquid surface of the chemical solution, thus preventing the upper surface of the semiconductor substrate from being wetted due to the fluctuation of the liquid surface of the chemical solution.

Even if there is no any vibration in the environment, after the semiconductor substrate is in contact with the liquid surface of the chemical solution, the upper surface of the semiconductor surface may be gradually wetted by the chemical solution that goes through the peripheral edges of the semiconductor substrate due to the effect of surface tension, i.e. siphon action. In the chemical processing method and device thereof according to the present invention, the lower surface of a semiconductor substrate is in contact with the chemical solution and wetted by jetting a chemical solution onto the lower surface of the semiconductor substrate. Therefore, while the lower surface of the semiconductor substrate is ensured to be in contact with the chemical solution, the chemical processing method and device thereof according to the present invention may increase efficiently the distance between the lower surface of the semiconductor substrate and the liquid surface of the chemical solution, thus preventing the occurrence of the siphonage of the chemical solution on the semiconductor substrate.

Also, the lower surface of the semiconductor substrate is ensured to be in contact and wetted with the chemical solution, the chemical processing method and device thereof according to the present invention may efficiently increase the distance between the lower surface of the semiconductor substrate and the liquid surface of the chemical solution, thus improving the stability of the semiconductor substrate on the shafts. In the case of when the semiconductor substrate is in contact with and floats on the liquid surface of the chemical solution, it is difficult for the semiconductor substrate to be stabilized on the shafts during the industrial production due to the influence of the buoyancy and the fluctuation of the liquid surface as well as the light weight of the semiconductor substrate itself. Particularly, in the case of continuous production wherein the semiconductor substrate is moved horizontally in a certain direction, the set moving direction of the semiconductor substrate is easy to be changed by the fluctuated liquid surface. The chemical processing method and device thereof according to the present invention may efficiently increase the distance between the lower surface of the semiconductor substrate and the liquid surface of the chemical solution, and in this case, the liquid surface tension causes a downward pull after applied on the lower surface of the semiconductor substrate, thus improving the stability of the semiconductor substrate on the shafts.

In the semiconductor industry, a gas may be generated during most of the chemical treatments of the semiconductor substrate. For example, hydrogen may be formed during the chemical etching process of the semiconductor substrate surface. Since the chemical processing method and device thereof according to the present invention may efficiently increase the distance between the lower surface of the semiconductor substrate and the liquid surface of the chemical solution, the gas generated during the chemical processing may be easily released from the lower surface of the semiconductor substrate, thus ensuring a normal chemical processing.

Furthermore, the chemical processing method and device thereof according to the present invention may be used in the case of when the lower surface of a semiconductor substrate is not in contact with the liquid surface of a chemical solution, if desired. In such case, the chemical solution is continuously or intermittently jetted onto the lower surface of the semiconductor substrate by using a nozzle, and thus the present invention can ensure not only that the complete wetting of the lower surface of the semiconductor substrate with the chemical solution, but also the continuous updating of the chemical solution under the semiconductor substrate, which is preferred for the chemical processing of the semiconductor substrate.

The chemical processing method and device thereof according to the present invention are suitable not only for the single-side treatment of a semiconductor substrate with a general thickness, but also for the single-side treatment of a semiconductor substrate with a thinner thickness. Specially, the present invention is more advantageous for the single-side treatment of the semiconductor substrate with a thickness of less than 300 µm.

### BRIEF DESCRIPTION OF THE DRAWINGS

Fig. 1 is a structural scheme illustrating that a semiconductor substrate moves into a chemical tank during a continuous processing;
Fig. 2 is a structural scheme illustrating that a nozzle begins to jet a solution when the semiconductor substrate moves to above the nozzle;
Fig. 3 is a structural scheme illustrating that a part of the lower surface of a semiconductor surface is wetted gradually;
Fig. 4 is a structural scheme illustrating that the lower surface of a semiconductor substrate is wetted completely and in contact with the liquid surface; and
Fig. 5 is a structural scheme illustrating that the lower surface of a semiconductor substrate is wetted completely but not in contact with the liquid surface.

The reference numbers in the drawings:
- 1: chemical tank
- 2: rolling shaft
- 3: nozzle (jet apparatus)
- 4: semiconductor substrate
- 5: chemical solution

### BEST MODE FOR CARRYING OUT THE INVENTION

The present invention will be further described in detail in reference to the drawings and specific examples, and could not be construed to be restricted thereby.

The present invention provides a method for chemically processing a surface of a semiconductor substrate, wherein a semiconductor substrate 4 to be processed is placed above a chemical solution 5 in a chemical tank 1 by shafts and the lower surface of the semiconductor substrate 4 is at a certain distance from the liquid surface of the chemical solution 5, then the lower surface of the semiconductor substrate 4 is processed chemically by jetting the chemical solution 5 onto the lower surface of the semiconductor substrate 4 via a jet apparatus 3.

The semiconductor substrate is a wafer made of a semiconductor material, such as silicon wafer, germanium wafer, etc., with a thickness of 50-500 µm.

It is preferred for placing the semiconductor substrate 4 horizontally above the chemical solution 5, but a slight tilt won't influence the effect of the invention.

The shaft 2, which may make the semiconductor substrate 4 be placed horizontally, may be realized by using a common technique in the art. Preferably, it can be a device with a transferring function, such as a shaft 2 with roller, to horizontally move the semiconductor substrate 4 in a certain direction, and thus performing a continuous treatment of the semiconductor substrate.

The lower surface of the semiconductor substrate 4 is at a certain distance of 0.1-10 mm, preferably 1-3 mm, more preferably 2 mm, from the liquid surface of the chemical solution 5. In the case of when the lower surface of the semiconductor substrate 4 is at a short distance from the liquid surface of the chemical solution 5, the jet apparatus 3 may jet the chemical solution 5 a bit weakly. In the case of when the lower surface of the semiconductor substrate 4 is at a long distance from the liquid surface of the chemical solution 5, the jet apparatus 3 may jet the chemical solution 5 a bit strongly. In order to prevent the chemical solution 5 jetted by the jet apparatus 3 from influencing the stability of the movement of the semiconductor substrate 4, the jetting height is about the distance between the upper opening of the jet apparatus and the lower surface of the semiconductor substrate.

The chemical solution may be a single-component or multi-component chemical solution.

As to the intensity that the jet apparatus (such as nozzle 3) jets the chemical solution 5, it is preferred that the lower surface of the semiconductor substrate 4 is wetted without affecting the stability of the movement of the semiconductor substrate 4. Preferably, the height that the jet apparatus 3 jets the chemical solution 5 above the liquid surface is equal to the distance between the lower surface of the semiconductor substrate 4 and the liquid surface of the chemical solution 5.

During the processing of the lower surface of the semiconductor substrate 4, both the semiconductor substrate 4 and the jet apparatus 3 may be in a stationary state, or they may move relative to each other. It is preferred that they move relative to each other.

In the case of when the semiconductor substrate 4 and the jet apparatus 3 move relative to each other, it may be that the jet apparatus 3 is stationary with the semiconductor substrate 4 moving in a certain direction, or the semiconductor substrate 4 is stationary with the jet apparatus 3 moving in a certain direction, or the semiconductor substrate 4 and the jet apparatus 3 move in reverse directions respectively; or the semiconductor substrate 4 and the jet apparatus 3 move at different speeds in the same direction. It is preferably that the jet apparatus 3 is stationary with the semiconductor substrate 4 moving in a certain direction.

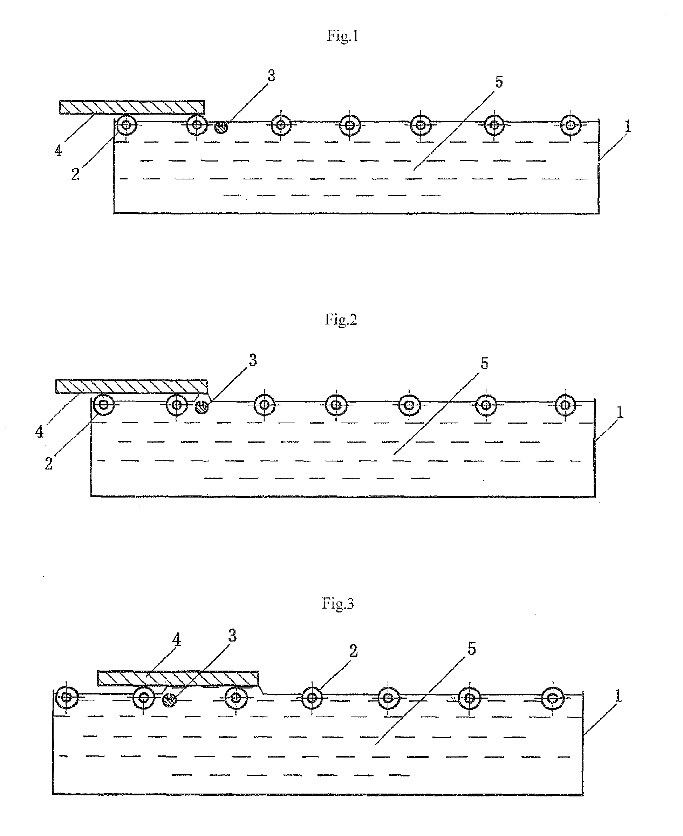

As shown in Fig. 2, when one end of the semiconductor substrate 4 moves to above the jet apparatus 3, the jet apparatus 3 begins to jet the chemical solution 5.

During the processing, the jet apparatus 3 may jet the chemical solution 5 intermittently or continuously. When the jetting is performed intermittently, it may be carried out one or more times.

In the case of when the lower surface of the semiconductor substrate 4 is at a short distance from the liquid surface of the chemical solution 5, the jet apparatus 3 may jet only once, and the whole lower surface of the semiconductor substrate 4 may be wetted gradually by the chemical solution 5 by means of surface tension, thus realizing the chemical processing of the lower surface of the semiconductor substrate 4. To increase the wetting speed of the chemical solution 5 on the lower surface of the semiconductor substrate 4, the jetting times of the jet apparatus 3 may increase. Of course, the jet apparatus 3 may also jet continuously during the processing. Preferably, the jet apparatus 3 jets the chemical solution 5 continuously during the moving over of the semiconductor substrate 4. By using the above preferred method for jetting the chemical solution and the preferred distance between the lower surface of the semiconductor substrate 4 and the liquid surface of the chemical solution 5, the lower surface of the semiconductor substrate 4 is kept in contact with the liquid surface of the chemical solution 5 contained in the chemical tank 1 during the whole chemical processing.

In the case of when the lower surface of the semiconductor substrate 4 is at a long distance from the liquid surface of the chemical solution 5, the jet apparatus 3 may jet continuously until the other end of the semiconductor substrate 4 moves to above the jet apparatus 3. In this case, the lower surface of the semiconductor substrate 4 is not in contact with the liquid surface of the chemical solution 5. During the processing, depending on the duration that the semiconductor substrate 4 moves over the jet apparatus 3 and the size of the semiconductor substrate 4, the jetting may lasts one to a few seconds, and the short the jetting time, the better it is.

In the chemical processing method according to the present invention, one or more jet apparatus 3 may be used. In the case of when one jet apparatus is used, it may jet once, several times or continuously. In the case of when more than one jet apparatus are used, each nozzle may jet once, several times or continuously.

In the case of when more than one jet apparatus are used, depending on whether the chemical solutions contained in different chemical tanks are same or not, the chemical solution 5 jetted by each jet apparatus 3 may be same or different.

When different jet apparatuses 3 jet different chemical solutions 5, it is preferred that the different chemical solutions 5 are contained in different chemical tanks 1.

The total width of each jet apparatus 3 (such as a nozzle) should be equal to the width of the semiconductor substrate. The width of the jet apparatus may be a bit smaller than that of the semiconductor substrate provided that the whole lower surface of the semiconductor substrate can be wetted. Preferably, the total width of the jet apparatus is a bit smaller than that of the semiconductor substrate 4.

When the semiconductor substrate 4 and the jet apparatus 3 move relative to each other, the moving speed may be slow or fast. In the case of when the jet apparatus 3 jets one time only, the moving speed is preferably slow to completely wet the other parts of the lower surface of the semiconductor substrate 4. In the case of when the jet apparatus 3 jets several times, the moving speed may be faster. In the case of when the jet apparatus 3 jets continuously, the moving speed may be much faster to reduce the processing time, which is suitable for large scale treatment.

When the lower surface of the semiconductor substrate 4 is at a long distance from the surface of the chemical solution 5 and the jet apparatus 3 jets continuously, several jet apparatuses 3 may be used and each jet apparatus 3 may jet different chemical solution 5 to continuously perform different chemical treatments on the lower surface of the semiconductor substrate 4. Here, the adjacent jet apparatuses 3 may be at a long or short distance. Preferably, the distance is longer than the length of the semiconductor substrate 4.

Therefore, the chemical processing method according to the present may process a single side of the semiconductor substrate 4 one or more times.

In semiconductor manufacturing industry, the above chemical solution may be any solution known by a skilled person in the art, such as sodium hydroxide solution with different concentrations or hydrofluoric acid with different concentrations, or the mixtures with one or more different solutions.

The device for chemically processing a surface of a semiconductor substrate according to the present invention includes a chemical tank 1 containing a chemical solution 5, a shaft 2 for supporting the semiconductor substrate 4 above the chemical solution 5, and a jet apparatus 3 for jetting the chemical solution 5 onto the lower surface of the semiconductor substrate 4.

The shaft may play a function of supporting the semiconductor substrate to make the semiconductor substrate above the chemical solution and is at a certain distance from the chemical solution.

Preferably, the shaft for supporting the semiconductor substrate has a transfer function, for example, it may have a roller, to make the semiconductor substrate move horizontally above the chemical solution.

The number of the jet apparatus may be one or more and the chemical solution jetted by each jet apparatus may be same or different.

The jet apparatus may be installed under or above the liquid surface of the chemical solution.

The height of the chemical solution jetted by the jet apparatus is equal to the distance between the lower surface of the semiconductor substrate and the upper opening of the jet apparatus.

The width of the jet apparatus is equal to that of the semiconductor substrate. It may also be a bit smaller than that of the semiconductor substrate provided that the whole lower surface of the semiconductor substrate could be wetted.

Also, the jet apparatus may move horizontally.

The chemical processing device according to the present invention may process the lower surface of the semiconductor substrate without wetting the upper surface of the semiconductor substrate.

The chemical processing method and device thereof according to the present invention may make the lower surface of the semiconductor substrate in contact with the chemical solution through jetting the chemical solution by using a jet apparatus, thus ensuring the reliability of a large scale production.

Fig. 1 is a structural scheme illustrating that the semiconductor substrate 4 moves into the chemical tank 1. The lower surface of the semiconductor substrate 4 is at a short distance of about 2 mm from the liquid surface of the chemical solution 5. The roller shaft 2 moves the semiconductor substrate 4 horizontally to close the nozzle 3. Here, the nozzle 3 does not jet the chemical solution 5, and the lower surface of the semiconductor substrate 4 is not in contact with the liquid surface of the chemical solution 5 and not wetted.

In fig. 2, the lower surface of the semiconductor substrate 4 is at a short distance of about 2 mm from the liquid surface of the chemical solution 5. when the roller shaft 2 moves one end of the semiconductor substrate 4 horizontally to above the nozzle 3, the nozzle 3 begins to jet chemical solution 5 to partially wet the lower surface of the semiconductor substrate 4.

In fig. 3, the lower surface of the semiconductor substrate 4 is at a short distance of about 2 mm from the liquid surface of the chemical solution 5. While the roller shaft 2 continues to move the semiconductor substrate 4 horizontally, chemical solution 5 is gradually in contact with and wets the other parts of the lower surface of the semiconductor substrate 4 due to surface tension effect. Here, the nozzle 3 may be in a state of jetting the chemical solution 5 continuously or in a state of stopping jetting. In the case of when the nozzle 3 is in the state of jetting the chemical solution 5 continuously, it may be in a state of moving either in a reverse direction to semiconductor substrate 4, or in a same direction but with a slower speed than the semiconductor substrate 4.

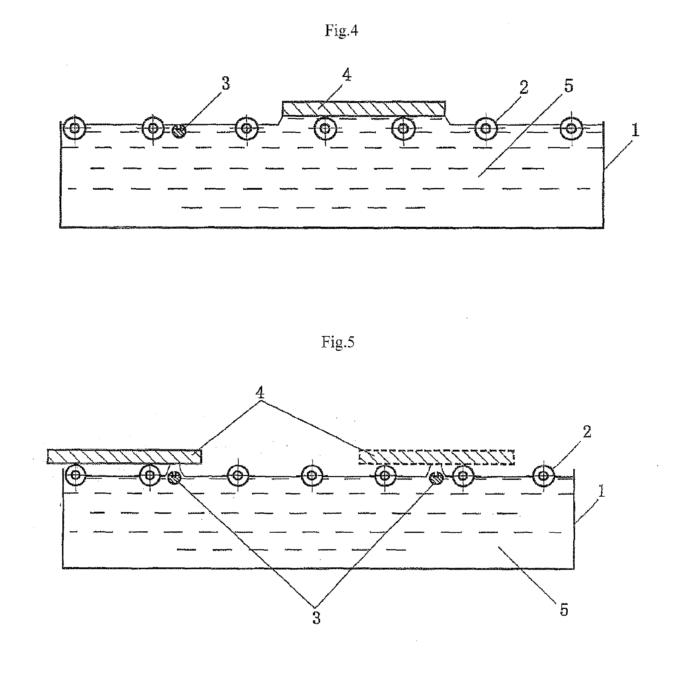

In fig. 4, the lower surface of the semiconductor substrate 4 is at a short distance of about 2 mm from the liquid surface of the chemical solution 5. The roller shaft 2 continues to move the semiconductor substrate 4 horizontally over the nozzle 3. Then the nozzle 3 stops jetting the chemical solution 5. The lower surface of the semiconductor substrate 4 is wetted completely by the chemical solution 5 and in contact with the liquid surface.

In fig. 5, the lower surface of the semiconductor substrate 4 is at a long distance of about 3 mm from the liquid surface of the chemical solution 5. When the roller shaft 2 moves the semiconductor substrate 4 horizontally to above the nozzle 3, the nozzle 3 begins to jet the chemical solution 5. Since the lower surface of the semiconductor substrate 4 is at a long distance from the liquid surface of the chemical solution 5, the chemical solution 5 can not be in contact with the lower surface of the semiconductor substrate 4 by means of surface tension effect. So the nozzle 3 jets the chemical solution 5 continuously during the movement of the semiconductor substrate 4 above the nozzle 3. When the semiconductor substrate 4 moves away from the above of the nozzle 3, its lower surface is wetted completely but not in contact with the liquid surface. The semiconductor substrate 4 moves forward continuously and may be processed again by the next nozzle 3. Also, the chemical solutions jetted by different nozzles 3 may be same or different, which depends on the actual requirement.

### Example 1

The chemical solution was a mixing solution of nitric acid and hydrofluoric acid. The jet apparatus was consisted of one nozzle and fixed. The lower surface of the semiconductor substrate is 2 mm above the liquid surface of the chemical solution. When one end of the semiconductor substrate moved to the above of the nozzle, the nozzle jetted the chemical solution one time. Then with the movement of the semiconductor substrate, its lower surface was wetted gradually by the chemical solution due to surface tension effect. During the whole processing, the lower surface of the semiconductor substrate kept in contact with the liquid surface of the chemical solution contained in the chemical tank. After the processing, it showed that the upper surface of the semiconductor surface was not wetted by the chemical solution.

### Example 2

The jet apparatus was consisted of several nozzles and fixed. The lower surface of the semiconductor substrate is 10 mm above the liquid surface of the chemical solution. When one end of the semiconductor substrate moved to the above of the nozzle, the nozzle began to jet the solution of hydrofluoric acid and continued until the other end of the semiconductor substrate moved to the above of the nozzle. Then the semiconductor substrate continued to move, and when one end of the semiconductor substrate moved to the above of the next nozzle, the nozzle began to jet the solution of hydrofluoric acid and continued until the other end of the semiconductor substrate moved to the above of the next nozzle. During the whole processing, the lower surface of the semiconductor substrate was not in contact with the liquid surface of the chemical solution contained in the chemical tank. After the processing, it showed that the upper surface of the semiconductor surface was not wetted by the chemical solution.

### Example 3

The chemical solution was a chemical nickelizing solution. The jet apparatus was consisted of one nozzle and fixed. The lower surface of the semiconductor substrate is 0.1 mm above the liquid surface of the chemical solution. When one end of the semiconductor substrate moved to the above of the nozzle, the nozzle began to jet the chemical nickelizing solution and continued until the other end of the semiconductor substrate moved to the above of the nozzle. During the whole processing, the lower surface of the semiconductor substrate kept in contact with the liquid surface of the chemical solution contained in the chemical tank. After the processing, it showed that the upper surface of the semiconductor surface was not wetted by the chemical solution.

### Example 4

The chemical solution was an isopropanol solution. The jet apparatus was consisted of several nozzles and fixed. The lower surface of the semiconductor substrate was 5 mm above the liquid surface of the chemical solution. When one end of the semiconductor substrate moved to the above of the nozzle, the nozzle began to jet the isopropanol solution and continued until the other end of the semiconductor substrate moved to the above of the nozzle. Then the semiconductor substrate continued to move, and when one end of the semiconductor substrate moved to the above of the next nozzle, the next nozzle began to jet the solution of hydrofluoric acid and continued until the other end of the semiconductor substrate moved to the above of the next nozzle. During the whole processing, the lower surface of the semiconductor substrate was not in contact with the liquid surface of the chemical solution contained in the chemical tank. After the processing, it showed that the upper surface of the semiconductor surface was not wetted by the chemical solution.

The processing method and device thereof according to the present invention are not only suitable for processing a certain surface of the semiconductor substrate. It is apparent for the person skilled in the art to make various improvements or modifications without departing from the spirit and scope of the present invention. Therefore, the application of the processing method and device thereof according to the present invention in processing a single surface of other objects will also fall in the protective scope of the present invention.

## Claims

1. A method for chemically processing a surface of a semiconductor substrate, comprising:
placing a semiconductor substrate above a chemical solution in a chemical tank by a shaft and making the lower surface of the semiconductor substrate be at a certain distance from the liquid surface of the chemical solution; and
chemically processing the lower surface of the semiconductor substrate by jetting the chemical solution onto the lower surface of the semiconductor substrate via a jet apparatus and thus wetting the lower surface of the semiconductor substrate.

2. The chemical processing method according to claim 1, wherein the semiconductor substrate is a wafer made of a semiconductor material and having a thickness of 50-500 µm.

3. The chemical processing method according to claim 1, wherein the lower surface of the semiconductor substrate is at a distance of 0.1∼10 mm from the liquid surface of the chemical solution.

4. The chemical processing method according to claim 3, wherein the lower surface of the semiconductor substrate is at a distance of 1∼3 mm from the liquid surface of the chemical solution.

5. The chemical processing method according to claim 1, wherein the chemical solution is a single-component or multi-component chemical solution.

6. The chemical processing method according to claim 1, wherein the chemical solution is jetted continuously or intermittently onto the lower surface of the semiconductor substrate by the jet apparatus.

7. The chemical processing method according to claim 1 or 6, wherein the height of the chemical solution jetted by the jet apparatus is the distance between the lower surface of the semiconductor substrate and the upper opening of the jet apparatus.

8. The chemical processing method according to claim 6, wherein the jetting is performed one or more times in the case of when the chemical solution is intermittently jetted onto the lower surface of the semiconductor substrate by the jet apparatus.

9. A device for chemically processing a surface of a semiconductor substrate, including:
a chemical tank for containing a chemical solution;
a shaft for supporting the semiconductor substrate above the chemical solution; and
a jet apparatus for jetting the chemical solution onto the lower surface of the semiconductor substrate.

10. The chemical processing device according to claim 9, wherein the shaft functions to transfer the semiconductor substrate horizontally in a certain direction.

11. The chemical processing device according to claim 9, wherein the chemical tank contains a chemical solution and is provided with the jet apparatus.

12. The chemical processing device according to claim 9, wherein one or more jet apparatus may be provided in the chemical tank, and the chemical solution jetted by each jet apparatus may be same or different.

13. The chemical processing device according to claim 9, wherein the jet apparatus has a width equal to or a bit smaller than that of the semiconductor substrate.
